Europäisches Patentamt

European Patent Office

Office européen des brevets

(19)

(11) **EP 0 747 666 B1**

(12) **EUROPEAN PATENT SPECIFICATION**

(45) Date of publication and mention
of the grant of the patent:
**13.02.2002 Bulletin 2002/07**

(51) Int Cl.[7]: **G01B 11/06**

(21) Application number: **96108686.5**

(22) Date of filing: **30.05.1996**

(54) **Method and apparatus for characterising multilayer thin film systems and for measuring the distance between two surfaces in the presence of thin films**

Verfahren und Apparat zur Charakterisierung eines Systems von mehrschichtigem Dünnfilm und zum Messen der Entfernung zwischen zwei Oberflächen in Anwesenheit von Dünnfilmen

Procédé et appareil pour la caractérisation d'un système multicouche de film mince et pour la mesure de la distance entre deux surfaces à la présence de films minces

(84) Designated Contracting States:
**DE FR GB NL**

(30) Priority: **06.06.1995 GB 9511760**

(43) Date of publication of application:
**11.12.1996 Bulletin 1996/50**

(73) Proprietor: **Holtronic Technologies Plc
London EC4A 1NH (GB)**

(72) Inventors:
• **Gray, Simon
2205 Montmollin (CH)**

• **Dandliker, René, Prof.
2035 Corcelles (CH)**
• **Schnell, Urban
2013 Colombier (CH)**

(74) Representative: **Riederer, Conrad A., Dr. et al
c/o Riederer Hasler & Partner Patentanwälte AG
Elestastrasse 8 Postfach
7310 Bad Ragaz (CH)**

(56) References cited:
**EP-A- 0 421 645          EP-A- 0 631 106
DE-A- 4 017 440          US-A- 5 129 724**

**Description**

The present invention relates to a method for characterising thin film systems comprised of one or more layers on a substrate.

Thin films on substrates are widely used, in diverse applications such as anti-reflection and other coatings in optics; for optical waveguides; for integrated circuit manufacture; for protective coatings, and so on. In many of these applications a precise "characterisation" is needed, i.e. measurements of the thickness and refractive index of the thin films, in order to control the deposition process and to ensure the correct functioning of the coating or finished device.

The most common methods for performing said thin film characterisations are mechanical profilometry and ellipsometry. Mechanical profilometry usually uses a stylus and necessitates contact with the surface to be measured. Furthermore it requires a destructive preparation of the sample and is prone to vibrations, which limits its accuracy. Ellipsometry necessitates a laser source and tends to be rather slow, complex and expensive. EP-A-0 639 753 discloses a method of measuring the thicknesses of a three- or four-layer system comprising a transparent insulation film, a silicon film and one or two transparent films, respectively. The method uses light of two wavelength ranges, namely light in the UV-range and light of a second range including longer wave-lengths than the UV-range. From the reflectance of the first wavelength range the thickness of the transparent film can accurately be calculated as most of the light is absorbed by the underlying silicon film. Approximate values for the thickness of the transparent insulation film and the silicon are calculated by frequency analysis whereby the spectrum components of the transparent film are eliminated by low-pass filtering. The approximate values obtained are then changed by a fixed amount and the deviations between the theoretical spectral reflectance and the measured spectral reflectance with respect to the varying thicknesses computed. The thickness values for the insulating film and the silicon film are then optimised by no-linear optimisation.

The described method has the drawback that it requires the prior measurement of the reflectance of a calibration wafer. This is time consuming and requires that the surface of the reference wafer does not deteriorate. Further, the method appears to be applicable just to a multi-layer system wherein the layer being disposed under the transparent film(s) absorbs light of the first wavelength range so that the spectral reflectance of the transparent film and hence its thicknesss can be calculated. Furthermore, as the method uses UV-light it is not applicable to multi-layer systems where one of the layers is UV-sensitive photo-resist. Still further, the method requires knowledge of the refractive indices to calculate the different layer thicknesses.

It is therefore desireable to provide a simple measuring method which allows fast and accurate measurement of the thickness and/or refractive index of thin films.

On the other hand there is the field of optical inspection techniques for measuring a specific parameter other than thin film characteristics. This parameter can be, for example, an absolute or a relative distance. For these techniques knowledge of film thicknesses and refractive indices are not, *per se*, necessary. For the case of measuring the distance between two surfaces an "interferometric" method, which measures the intensity of the interference between light beams reflected from the two said surfaces, is often used. However when a multi-layer, or even a single layer, system is present, phase shifts due to reflections from the layers may prevent accurate interferometric measurements of the parameter being sought.

Examples of such techniques are optical profilometers, micropositioning devices, and focusing systems as used in microscopy and in microlithography for integrated circuit manufacture.

Previous interferometric methods for distance measurement do not take into account the phase shift introduced by reflection from a thin film stack, and measurement errors can result. The consequences of said measurement errors due to phase shifts in multi-layer systems are, for instance, that an optical profilometer may have difficulty measuring the profile of coated surfaces, or that a microlithographic imaging system using an interferometric focusing system may print patterns at the incorrect focus, leading to blurring of the image.

EP-A-0 631 106 discloses a method and apparatus for measuring the thickness of a thin semiconductor multi-layer film. It proposes to use Fourier transform spectroscopy for evaluating the thickness of the different layers. In particular, the technique involves continuously measuring the reflected light over a range from the visible light to the far infrared light and removing the optical transmitting characteristic of the spectroscopic apparatus from the measured spectrum so that only the multi-layer film interference remains. The spectrum thus obtained is reverse Fourier transformed to produce a spatialgram by calculation. From the side burst peaks approximate values for the film thickness are obtained which are used for calculating a theoretical interference spectrum. The theoretical interference spectrum is fitted to the measured interference by a least squares routine which produces still better values for the film thickness. This procedure is repeated until the theoretical interference is best fitted to the measured interference spectrum. The method of EP-A-0 631 106 has the advantage that it allows the determination of the film thickness of a thin film multi-layer system. A disadvantage of EP-A-0 631 106, however, is that it requires mechanical movement of the reference mirror which makes it a slow technique.

It is, therefore, an object of the present invention to provide a method for characterising a single- or multi-layer thin film system on a substrate, in terms of the thickness and refractive index of the layers present.

A further object is to provide a way of optically measuring the distance between two essentially parallel surfaces, at least one of which may be coated with a single- or multi-layer, such that an accurate measurement of the distance is obtained irrespective of the number or type of layers present.

A still further object is to provide a method for correcting the phase shifts from one or more layer thin film systems in interferometric optical inspection techniques.

According to the invention there is provided a method for characterising a one or more layer system on a substrate, in particular in respect of layer thickness and refractive index, by interferometry, in particular by white-light channelled spectrum interferometry or multi-wavelength interferometry, comprising the following steps:

a) directing a light beam towards an interferometer comprising two essentially parallel reflecting surfaces separated, or whose path lengths differ by, a distance D, and at least one surface of which is a one or more layer system, wherein the layers to be characterised are at least partially transparent to the selected wave-lengths

b) directing at least a part of the light reflected from the two interfering surfaces onto a grating, thereby dispersing the reflected light,

c) focussing the dispersed light onto a photo detector array ("PDA"),

d) evaluating the phase of the interference pattern at each PDA element, using the measured intensity values, to give the "measured phase function", i.e. the phase of interference as a function of frequency.

e) fitting the phase function model to the measured phase function, wherein the phase function model is as follows:

$$\Phi(\nu) = \Phi_0 + \frac{4\pi}{c}\, D\nu + \delta_r(\nu;n_i, d_i) \tag{1}$$

where

$\delta_r$ is the phase contribution of the multi-layer system, c is the speed of light and the parameters in bold are the parameters of the phase function model, the number of which is M:

$n_i$ and $d_i$ are the refractive index and thickness of the i-th layer, respectively;

$\Phi_0$ is a phase offset due to the method of phase determination;

$D$ is the distance between the two interfering surfaces or the path length difference between the two interfering arms of the interferometer,

and

f) determining the parameters of the phase function model which best fit the measured phase function.

This inventive method has the advantage of being - compared to ellipsometry - a rather fast measuring method which produces absolute measurement values from a simple optical arrangement and, compared to stylus techniques, is a noncontact and non-destructive method. In contrast to previous interferometric methods for distance measurement, this method takes into account the phase shift produced on reflection at thin film stack, allowing compensation of the measured phase and avoiding a distance measurement error. It allows the fast, accurate and simultaneous determination of the refractive indices and layer thicknesses of one or more layers. In practice, however, the most interesting parameter to be determined is the layer thickness, as the refractive index may often be accurately known.

In contrast to the method disclosed in EP-A-0 639 753 the present method is not limited to specific multi-layer systems and it does not require the use of a calibration wafer. Furthermore it does not require knowledge of the refractive indices of the layers whose thicknesses are to be determined.

In certain common cases a multi-layer system may include an essentially opaque layer such as a metal. In such a case the inspection beam does not reach the layers between the opaque layer and the substrate. It may be preferable in such a case to treat the opaque layer as the substrate and to ignore the layers between the opaque layer and the substrate.

Preferably the interferometer is comprised of two surfaces separated by a distance D or of a Michelson interferometer, the interfering arms of which have a path difference of D.

It is therefore clear that this method is equally useful for measuring the distance D between two surfaces, being essentially parallel, and more particularly for measuring the distance between two surfaces wherein at least one of said surfaces is coated with at least one layer.

Preferably the light beam is from a broad-band or a multi-wavelength source or a light-emitting diode (LED). These light sources are commercially available at a reasonable price. Depending on the measurement problem a window of the emission spectrum may be selected.

A least squares fitting may be used for fitting the phase function model to the measured phase function. Least squares fitting is a well known numerical analysis tool for modelling data. There are ready made programs commercially available which can easily be adapted to the solution of the numerical problem. Reference may be had for example to "Numerical Recipes in Pascal" by WH Press et al (Cambridge University Press 1992). There are many kinds of methods e.g. linear least squares fit, Levenberg-Marquardt method and Gauss-Newton method. The best choice of the method mainly depends on the problem to be resolved. The following conditions have to be fulfilled when a least squares algorithm is used:

- the knowledge of a model is mandatory.
- the number of data points must be larger than the number of parameters of the model.

In the case of the described white-light channelled spectrum interferometer for the characterisation of multi-layer systems, both conditions are easily fulfilled (i.e. a model of the phase function is known and the number N of local phases $\Phi_n$ (data points) can easily be larger than the number M of parameters of the model).

Preferably a synchronous sampling with four samples per interference fringe is employed wherein the grating constant, the distance between adjacent pixels of the photo detector array and the focal length of the relay lens are chosen and arranged, with respect to the approximate distance D and the central wavelength or frequency of the illumination source, such that each pixel of the photo detector array measures the light of a certain wavelength or frequency $\nu_n$, the frequency spacing between two adjacent pixels $\Delta\nu$ corresponding to a phase separation in the interference pattern of $\Delta\Phi_s=\pi/2$. This makes the phase evaluation simple and minimises the hardware requirements, although in principle any value of $\Delta\Phi_s$ smaller than $\pi$ may be used

The number of measuring points is determined by the number of elements in the PDA and the spectral bandwidth of the source. It is appropriate that the number of measuring points N exceeds the number of parameters M to be determined. In such a case we have redundant data available and by a least squares fitting the parameters can be determined accurately. The most accurate results of the least squares algorithm can be expected when the number of data points to fit and the total spectral range resolved by the photo detector array are large. A minimum number of data points on the other hand results in a short computing time but less reliable values of the fitting parameters. In many cases 100 to 200 measuring points are a good choice between computation time and accuracy. However, it is also possible to use just a few tens of data points.

Under certain conditions it may be convenient to use estimates for the parameters to be determined as starting points for the fitting procedure. Good estimates for the refractive indices are, for example, often known and available. But also the layer thickness may be estimated according to prior knowledge of the deposition process. If such estimates are available, the method is still more efficient and fast.

It is also possible to use a second independent method for determining the refractive index and layer thickness of each layer and to use these parameters further for calculating the term $\delta_r$ so that the phase function model has fewer parameters, thus speeding up and simplifying the fit to the measured phase function. Such an approach may be used with a deposition process which is tightly controlled and where thin film thicknesses and refractive indices are accurately known.

For a better understanding of the method reference is made to the following detailed description and mathematical background to the invention.

The simultaneous measurement of the distance D and characterisation of the multi-layer system are carried out according to the following method:

The interference signal is sampled with the photo detector array in order to get N samples $s_n$, where N is the number of pixels of the photo detector array and $1 \leq n \leq N$.

The N-4 local phases $\Phi_n$ are computed using five adjacent samples of the interference signal centered at the sample $s_n$, through :

$$S_n = s_{n-1} - s_{n+1} = 2B \sin\Delta\Phi_s \sin\Phi_n$$

$$C_n = s_n - \frac{s_{n+2} + s_{n-2}}{2} = 2B \sin^2\Delta\Phi_s \cos\Phi_n$$

$$\Phi_n = \tan^{-1}\left(\frac{s_n \sin\Delta\Phi_s}{C_n}\right) \qquad (2)$$

The local phases $\Phi_n$ are unwrapped (which is possible since $\Delta\Phi_s = \Phi_n - \Phi_{n-1} = \pi/2$ and $\Phi_n > \Phi_{n-1}$) in order to get the measured phase function,

$$\Phi = \Phi(\nu_n) \qquad (3)$$

A model of the measured interference phase as a function of the optical frequency $\nu$ can be written as,

$$\Phi(\nu) = \Phi_0 + \frac{4\pi}{c} D\nu + \delta_r(\nu; n_i, d_i) \qquad (4)$$

where the symbols are as defined in Eqn.1, $\delta_r$ being the phase contribution of the multi-layer system.

Since interferometry is sensitive to phase, a distance measurement error can occur when the distance D is calculated from the measured phase function of Eqn (3) without taking into account the phase contribution $\delta_r$ of the multilayer system. In order that the measurement of D be independent of the phase contribution of the multi-layer system it is necessary to take into account the phase contribution $\delta_r$ of the multi-layer system and it is therefore mandatory to dispose of a model for $\delta_r$.

Such a model can be derived using the addition of multiple reflections from a system of multiple stratified layers as developed in some detail in many textbooks. Expressions may be derived for the intensity and phase of the reflected light from a given stratified layer system if certain information is available, for example the number of layers and type of substrate present. In the case of more than two layers the method of addition of multiple reflections becomes impractical. In such a case a more elegant approach, such as that described by Azzam and Bashara (Ellipsometry and Polarised Light, North-Holland Personal Library (NHPL), Amsterdam, Holland, 1987, pp. 283-286, 332-340), may be used, in which the intensity and phase of the reflected light from a stratified layer system can be expressed in terms of a 2 x 2 matrix. Again the general expressions derived by Azzam and Bashara may be applied to the particular multi-layer system being measured.

As the general approach involves fitting a phase function model to a measured phase function then the fewer the parameters of the model, the faster is the fitting procedure. It follows that the fewer the layers and the more the known parameters, such as refractive index of layers, the more efficient is the method. This is illustrated later in the form of examples. The method described is however valid for any number of layers.

When the parameters $(n_i, d_i)$ of the multilayer system are known, a correct interpretation of the measured phases, which is possible due to the model of phase contribution $\delta_r$, allows to avoid the distance measurement error. To determine the parameters of the multilayer system *in situ*, it is necessary to use a suitable algorithm, as described above and later in the examples, to fit the phase function model to the measured phase function.

When N>M (redundancy), a least-squares algorithm is used to fit the phase function model in Eq.(4) to the measured phase function in Eq. (3) in order to find the best fitting values $\Phi_{0fit}$, $D_{fit}$, $d_{ifit}$ and $n_{ifit}$ of the M fitting parameters.

A particular application of the above method is in Total Internal Reflection (TIR) holography for determining the correct distance between a hologram surface and a coated substrate surface which is arranged in proximity to, and essentially parallel with, the hologram surface.

In TIR holography a photo mask pattern of a microstructure such as an integrated circuit (IC) is first holographically recorded in a photosensitive layer (such as a holographic photopolymer) on a glass substrate in optical contact with a prism. In a second step the hologram is illuminated, causing the holographic image to be projected onto a second photosensitive layer (such as photoresist) coated on a wafer or other substrate, e.g. glass. For reference see for example K. A. Stetson in Applied Physics Letters (June 1968).

During hologram recording the photomask is held in proximity to the holographic recording layer at a distance L. In hologram replay a real image of the photomask is created in space at the same distance L from the hologram. At this distance L a substrate such as a wafer, having a photosensitive coating is positioned, hence the image of the photomask is projected onto said photosensitive layer. This process is usually repeated many times for a plurality of coated substrates.

It can be seen that in TIR holography a key parameter is the distance L, which is known as the focal length or focus of the hologram. An accurate measurement of L is necessary during hologram recording so as to be exactly measured and positioned during hologram replay.

In order to assure that the holographic image is printed at the correct focus, EP-A-0 421 645 discloses a TIR holographic system where the distance between the hologram and wafer can be adjusted by means of actuators. Further, it proposes an inspection light beam to measure the distance between the hologram and the wafer by an interferometric technique. Said inspection light beam may be furthermore moved in synchronisation with a scanning movement of the replay beam during reproduction of the holographic image.

Said interferometric inspection technique may suitably be a dual- or multi-wavelength interferometer, a white-light interferometer or a channeled spectrum interferometer. Such interferometric methods produce reliable results in the case where there are reflections from only two surfaces.

In realistic systems, however, where one or more layers or thin films are already deposited on a wafer substrate, phase shifts produced by multiple reflections at the layer interfaces prevent an accurate distance measurement. In the minimum case the photosensitive layer (e.g. photoresist) is present. In the general case several layers such as silicon oxide, silicon nitride, or any other layer are previously deposited. The phase contribution due to multi-layers was not addressed in EP-A-0 421 645. Such phase shifts can provoke distance measurement errors of several microns, depending on the phase shift produced by the multi-layer system, leading to corresponding focus errors in the printed image.

As seen above, in TIR holographic lithography the maintenance of an accurate focus is crucial. So far no solution is known which would correct for phase shifts due to multiple reflections from the different surfaces when an interferometric technique is used for focus determination. Preferably, the distance measurement is used for adjusting and maintaining focus during the holographic printing process. A correct distance measurement, irrespective of the number of layers, enables high-resolution features in the sub-micron region to be printed.

The most preferred phase function model to be used for the afore-mentioned purpose of TIR holographic lithography can be written as

$$\Phi(\nu) = \Phi_0 + \frac{4\pi}{c} L\nu + \delta_r(\nu; n_i, d_i) \tag{5}$$

where **L** is the air gap between the hologram surface and the wafer surface and the other symbols are as defined in Eqn(1).

The method can be performed on a system for measuring the distance between two surfaces being essentially parallel, and more particularly for measuring the distance between two surfaces wherein at least one of said surfaces is coated with at least one layer, the system comprising:

- a white light or broad-band source,
- collimating means for collimating the light beam,
- focusing means for focusing the light beam onto the surfaces,
- a diffraction grating,
- means for directing the reflected light towards said diffraction grating and
- a photo detector array arranged in respect to the diffraction grating and a relay lens for detecting the reflected and dispersed light beam,

wherein the grating constant, relay lens and pixel spacing of the photo detector array are chosen and arranged relative to the central wave-length of the light source and to the approximate distance L such that a synchronous sampling with at least three samples per interference fringe period are obtained.

In a preferred embodiment the incident light beam is at an angle of approximately 90 degrees so that the reflected beams essentially coincide at the photo detector array. There may be reflections from several surfaces, i.e. boundaries where the refractive indices change. However in principle there could be any angle, provided that the reflected beams interfere, which in practice means they are largely superimposed at the detector array.

Appropriately the light source is a broad-band or white light source. This allows unwrapping of the measured phases.

In a particular embodiment the apparatus described is used for focus measurement in a TIR holographic lithography system, wherein the distance to be measured is the distance L between the surface of the hologram and the singly or multiply coated surface of the substrate to be printed onto.

Conveniently the white light source is a halogen lamp working at a center wavelength of 633nm with a spectral bandwith of approximately 100nm, the spatial period of the grating is 577.36 nm, and the angle of incidence of the reflected light beam on the grating is 33.2 degrees. The distance between adjacent pixels of the photo detector array is 25 microns, the focal length of the relay lens is 60mm and the distance to be measured is approximately 125 microns.

For a better understanding of the invention, reference may be made to the following detailed description taken in conjunction with the accompanying drawings in which

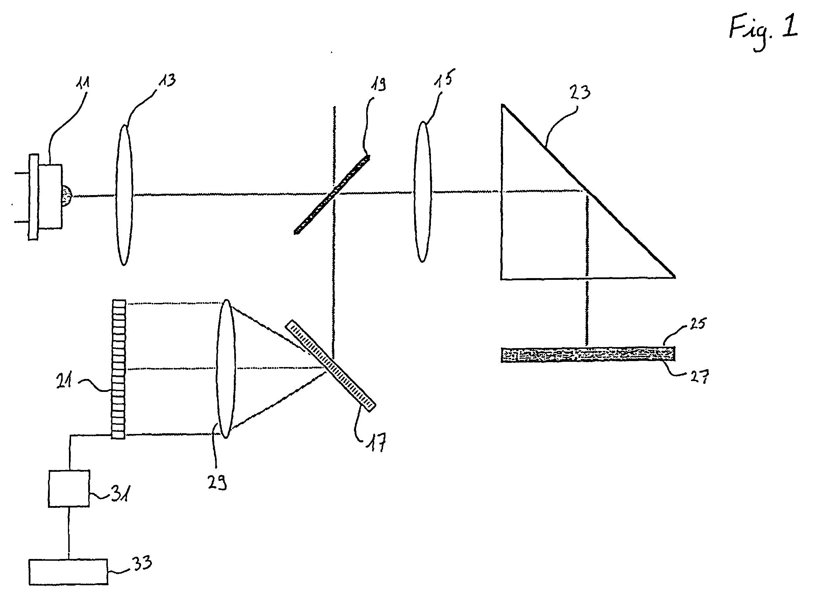

Figure 1     is a schematic drawing of an interferometric measuring system used in a TIR holographic apparatus for measuring the gap between a coated substrate and a hologram in a Total Internal Reflection (TIR) holographic system,

Figure 2 is a magnified detail from Fig.1 showing the coated substrate and the hologram,

Figure 3 shows the principle of synchronous sampling with four samples per period of interference.

The interferometer essentially comprises a white-light or broad-band source 11, collimating and focussing means 13 and 15, a grating 17, a beam splitter 19 and a photo detector array 21. In operation the beam of the white-light source 11, normally a halogen lamp, a light emitting diode (LED) or the like, is collimated by the lens 13 and focussed by lens 15. The beam is thereby directed through the prism 23 onto the test surface 25, being the upper surface of a substrate 27 or wafer. The incident light beam is preferably at an angle of 90 degree to the test surface 25. Thus, the incident and the reflected light beam essentially coincide. The beam splitter 19 directs the reflected light beam to the grating 17 which disperses the reflected light beam. The dispersed light beam is then focussed by a lens 29 onto the photo detector array 21 which comprises a large number of pixels. The signals from the detector array 21 are supplied to an electronic control unit 31 and then to a computer 33. From the intensity distribution of the light the distance, refractive index, layer thicknesses and phase contribution from the multilayer system can be calculated.

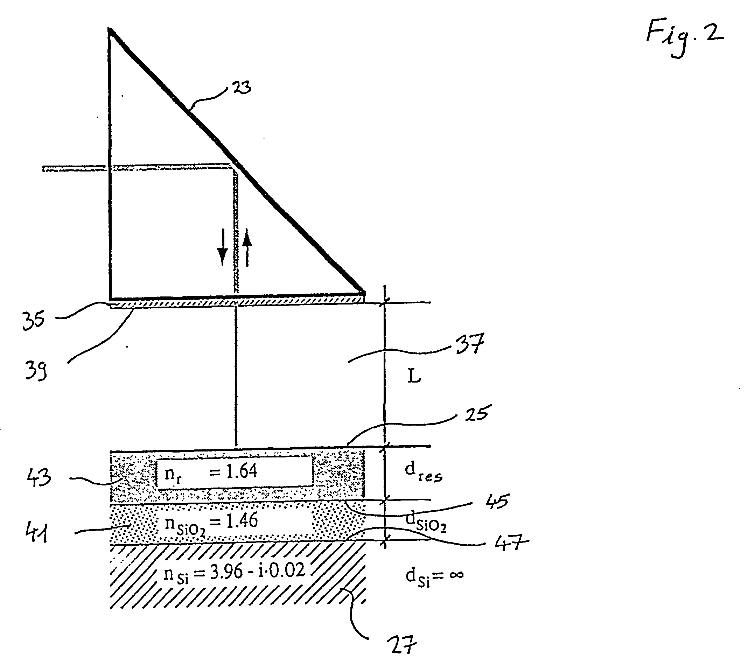

As can be seen more clearly from Fig. 2 the wafer 27 is arranged in proximity and parallel to the hologram 35 which is in optical contact with the lower prism surface. A small air gap 37 of a distance L separates the hologram surface 39 from the surface 25. Hologram surface 39 and the surface 25 form an interferometer. The substrate surface is coated with two layers: a $SiO_2$ layer 41 and a layer of a photoresist 43. When a light beam is directed at a 90 degree angle onto the substrate 27 it will penetrate also the two layers or thin films 43 and 41. At the boundaries where the refractive index changes part of the light beam will be reflected. Thus we have reflections from the surfaces 39, 25, 45 and 47. In essence we can still consider the interferometer as being formed by the reflections from surfaces 39 and 25, but the reflections from 45 and 47 introduce a phase shift to the beam reflected from 25. If the phase shift produced by the multiple reflections described is not accounted for in the measurement algorithm, then a distance measurement error will be introduced, resulting in an out-of-focus image being printed onto the wafer. The magnitude of the phase shift and hence the distance measurement error vary according to the layers present and bandwidth used, but may exceed several microns. For high resolution printing such errors are unacceptable.

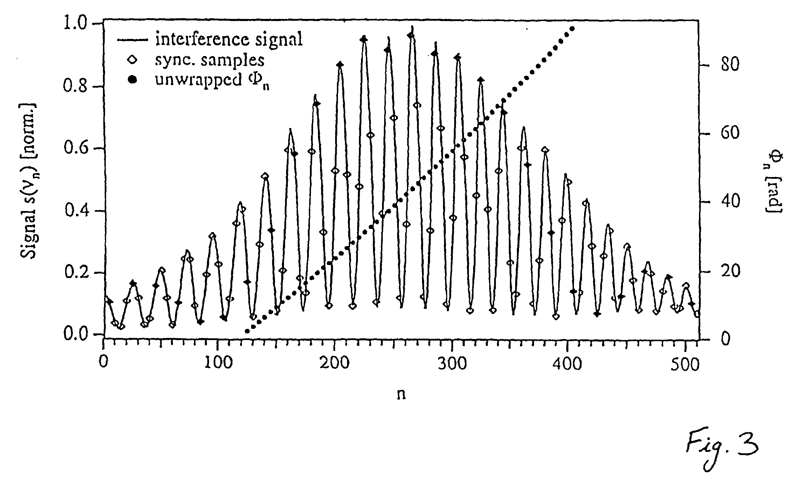

The dispersion created by the diffraction grating is such that the difference in frequency $\Delta v$ between two adjacent pixels n and n-1 of the photo detector array results in a phase difference of $\Delta\Phi_s = \pi/2$ between two adjacent samples $s_n$ of the measured interference pattern. With reference to figure 3, the observed fringes in the spectrum are synchronously detected, with four samples per fringe period to calculate the fringe phases. In the figure every fourth sample is graphically emphasized to demonstrate that the sampling is (nearly) synchronous to the fringe pattern.

Important characteristics of the apparatus are the dimensions of 17, 29 and 21. As previously described the interference phase difference between adjacent pixels of the photo detector array (PDA) should be smaller than $\pi$, although it is most convenient if this separation is $\pi/2$. The diffraction grating 17, the relay lens 29 and the PDA 21 are therefore selected and aligned according to the central wavelength of the source and the distance to be measured in order to fulfil this condition.

The method is now illustrated with reference to four examples and to the remaining figures, in which

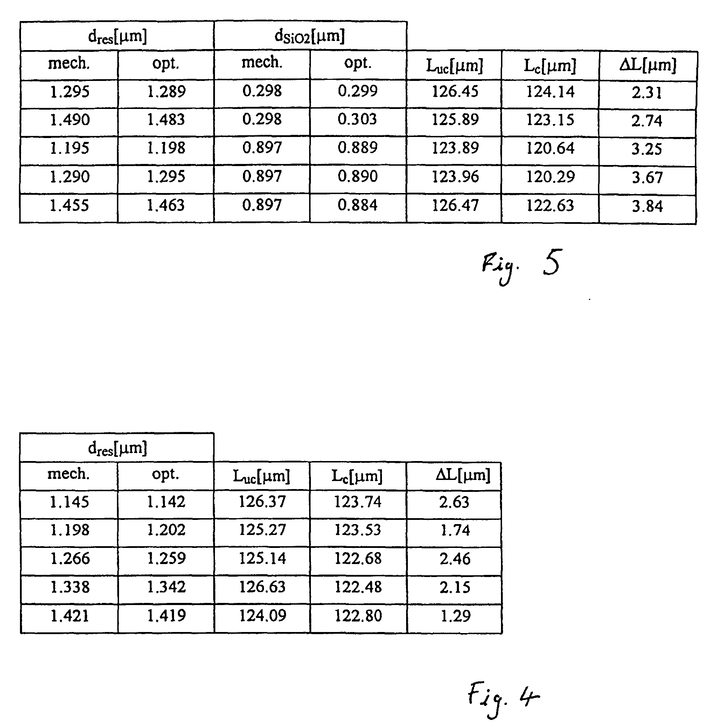

Figure 4 is a table of measurements of the distance L between a hologram surface and a photoresist-coated silicon wafer surface and $d_{res}$, the thickness of photoresist, obtained using the current method.

Figure 5 is a table of measurements of L, $d_{SiO2}$ and $d_{res}$, the thickness of $SiO_2$ and photoresist layers on a silicon wafer, obtained using the current method.

**Absolute distance measurement without multi-layer**

When no multi-layer system is present (i.e. a bare substrate), the phase function model in Eq. (4) can be written as

$$\Phi(v) = \Phi_0 + \frac{4\pi}{c} Lv \qquad (6)$$

A non-iterative linear least squares algorithm is used to fit the phase function model in Eq. (4) to the measured phase function in Eq. (3) in order to find the best fitting values $\Phi_{0fit}$ and $L_{fit}$ of the parameters $\Phi_0$ and L, respectively.

**Photo-resist on Silicon**

In the case of a photo-resist layer on a Si substrate, the phase model in Eq. (4) can be written as

$$\Phi(v) = \Phi_0 + \frac{4\pi}{c} Lv + \delta_r(v;d_{res}) \tag{7}$$

assuming that the refractive index of the photoresist ($n_{res}$) and the Si substrate ($n_{Si}$) are independent of the optical frequency $v$. A commercially available Levenberg-Marquardt method, for example as implemented in "Optimisation Toolbox for use with MATLAB", The Mathworks, Inc., Natick, Mass. 01760-1500, 1994, can be used for the one-fold non linear fitting of Eq. (7) to the measured phase function in Eq. (3) to find $\Phi_0$, L and $d_{res}$. Figure 4 shows a table of measurements of photoresist thickness $d_{res}$ obtained using the current optical method. Values measured with a mechanical profilometer are shown for comparison. $L_{uc}$ is the measurement of L without correction for the phase shift due to the photoresist layer, $L_c$ is the corrected value, and $\Delta L$ is the difference between $L_{uc}$ and $L_c$.

A similar approach may be used when, in a multi-layer system, the final layer before the photoresist layer is an essentially opaque layer such as a metal. In such a case the multi-layer system behaves essentially as a single layer system with the opaque layer as the substrate.

**Photoresist on SiO2 on Si**

In the case of a multi-layer system formed by a photoresist layer on a $SiO_2$ layer on a Si substrate, the phase model in Eq.(4) can be written as

$$\Phi(v) = \Phi_0 + \frac{4\pi}{c} Lv + \delta_r(v;d_{res}, d_{SiO2}) \tag{8}$$

assuming that the refractive indices of the photo resist ($n_{res}$) and the silica ($n_{SiO2}$) are independent of the optical frequency. A two-fold non linear fitting of Eq.(8) to the measured phase function in Eq. (3) can be used to find $\Phi_0$, L, $d_{res}$ and $d_{SiO2}$. Figure 5 shows a table of values of photoresist and silicon dioxide thicknesses obtained using the current method. Values measured with a mechanical profilometer are shown for comparison. $L_{uc}$ is the measurement of L without correction for the phase shifts due to the photoresist and $SiO_2$, layers. $L_c$ is the corrected value, and $\Delta L$ is the difference between $L_{uc}$ and $L_c$.

**Known Multi-Layer System**

It is clear that if the values $n_i$, $d_i$ are previously known (from another type of measurement for example), then $\delta_r$ can be calculated directly from the model. In such a case, a non-iterative least squares algorithm is sufficient to fit the phase function model in Eq. (5) to the measured phase function in Eq. (4) in order to find the best fitting values $\Phi_{0fit}$ and $L_{fit}$ of the parameters $\Phi_0$ and L respectively.

Thus the described method is particularly useful in determining the correct distance between two surfaces where there are one or more layers on one of the surfaces, e.g. wafer coated with one layer in a TIR holographic system. It can also be seen from the previous description that the method can be successfully applied to optical profilometers. Profilometers measure the distance between a reference surface and a profiled second surface. If the profile to be determined has a coating then the measurements are not correct. This problem has not been addressed so far in the art. The use of the known profilometers are therefore restricted to the measurement of the distance between two surfaces. In this respect the present method will increase the versatility of the known profilometers.

**Claims**

1. Method for **characterising** a one or more layer thin film system on a substrate (27), in particular in respect of layer thickness and refractive index, by interferometry, in particular by white-light channelled spectrum interferometry or multi-wavelength interferometry, comprising the following steps:

   a) directing a light beam towards an interferometer comprising two essentially parallel reflecting surfaces separated by or whose path lengths differ by, a distance D, and one surface of which is a one or more layer system (27,41,43), wherein the layers to be **characterised** are at least partially transparent to the selected wavelengths

   b) directing at least a part of the light reflected from the two interfering surfaces onto a grating (17), thereby dispersing the reflected light,

   c) focussing the dispersed light onto a photo detector array (21),

   d) evaluating the phase of the interference pattern at each photo detector array element, using the measured intensity values, to give the measured phase function, i.e. the phase of interference as a function of frequency,

e) fitting the phase function model to the measured phase function, wherein the phase function model is as follows:

$$\Phi(\nu) = \Phi_0 + \frac{4\pi}{c} D\nu + \delta_r(\nu; n_i, d_i)$$

where $\delta_r$ is the phase contribution of the multi-layer system, c is the speed of light and the parameters in bold are the parameters of the phase function model:

$n_i$ and $d_i$ are the refractive index and thickness of the i-th layer, respectively;

$\Phi_0$ is a phase offset due to the method of phase determination;

$D$ is the distance between the two interfering surfaces or the path length difference between the two interfering arms of the interferometer, and

f) determining the parameters of the phase function model which best fit the measured phase function.

2. Method according to claim 1 wherein the light beam is from a broad-band or a multi-wavelength source or a light emitting diode

3. Method according to claim 1 or 2 wherein a least squares fitting is used for fitting the phase function model to the measured phase function.

4. Method according to one of the claims 1 to 3 wherein the grating (17), the distance between adjacent pixels of the photo detector array (21) and the focal length of the relay lens (29) are chosen and arranged with respect to the distance D and the central wavelength or frequency of the illumination source such that each pixel of the photo detector array measures the light of a selected wavelength or frequency.

5. Method according to claim 4 wherein the said components are arranged such that adjacent pixels are separated by a frequency $\Delta\nu$ corresponding to a phase separation in the interference pattern of $\pi/2$.

6. Method according to one of the claims 1 to 5 wherein the number of measuring points N exceeds the number of parameters M to be determined.

7. Method according to one of the claims 1 to 6 wherein estimates for the parameters to be determined are used as starting points for the fitting procedure.

8. Method according to claim 1 to 7 as used in a Total Internal Reflection holography configuration for determining the correct distance L between a hologram surface (39) and a coated substrate surface (25) which is arranged in proximity to and essentially parallel with the hologram surface (39).

9. Method according to claims 8 wherein the substrate (27) is coated with one or more layers (41,43).

10. Method according to claims 8 or 9 wherein the distance measurement is used for adjusting and maintaining focus.

11. Method according to one of the claims 8 to 10 wherein the phase function model can be written as

$$\Phi(\nu) = \Phi_0 + \frac{4\pi}{c} L\nu + \delta_r(\nu; n_i, d_i)$$

where L is the distance to be measured and the other symbols are as defined in claim 1.

12. Method according to one of the claims 8 to 11 wherein a second independent method is used for determining the refractive index and layer thickness of each layer and wherein the parameters determined are further used for calculating the term $\delta_r$ so that the phase function model has fewer parameters, thus speeding up and simplifying the fit to the measured phase function.

13. Method according to claim 1 to 12, wherein the method is performed on a interferometric system for measuring the distance between two surfaces being essentially parallel, and more particularily for measuring the distance between two surfaces whereas at least one of said surfaces is coated with at least one layer, the system comprising:

- a white light or broad-band source (11),
- collimating means for collimating the light beam (13),
- focusing means (15) for focusing the light beam onto the surfaces (39,25,45,47),
- a diffraction grating (17),
- means (19) for directing the reflected light towards said diffraction grating and
- a photo detector array (21) arranged in respect to the diffraction grating (17) and to a relay lens (29) for detecting the reflected and dispersed light beam,

wherein the grating constant, the focal length of the relay lens (29) and the pixel spacing of the photo detector array (21) are chosen and arranged relative to the central wave-length of the light source and to the approximate distance L such that a synchronous sampling with at least three samples per interference fringe period are obtained.

14. Method according to claim 13 wherein the incident light beam is at an angle of approximately 90 degree so that the reflected beams essentially coincide at the photo detector array (21).

15. Method according to claim 13 or 14 wherein a beam splitter (19) deflects the reflected light towards the grating (17).

16. Method according to claims 13 to 15 wherein the two surfaces are the hologram and substrate in a Total Internal Reflection holographic lithography system and the distance measurement is used for determining the focus position.

17. Method according to one of the claims 13 to 16 wherein the light source (11) is a white light source.

18. Method according to one of the claims 13 to 16 wherein the white light source (11) is a halogen lamp working at a center wavelength of 633nm with a spectral bandwith of approximately 100 nm, the spatial period of the grating is 577.36 nm, and the angle of incidence of the reflected light beam on the grating is 33.2 degrees, the distance between adjacent pixels of the photo detector array is 25 microns, the focal length of the relay lens is 60mm and the distance to be measured is approximately 125 microns.

19. Method according to claim 1 to 18 for use e.g. in a profilometer for determining the distance between a reference surface and a profiled second surface.


**Patentansprüche**

1. Verfahren zum Charakterisieren eines Ein- oder Mehrschichten Dünnschichtsystems auf einem Substrat (27), insbesondere bezüglich Schichtdicke und Brechungsindex, mittels Interferometrie, insbesondere mit Weisslicht-Interferometrie mit diskreten Spektralbereichen ("channelled spectrum interferometry ") oder Multi-Wellenlängen-Interferometrie, charakterisiert durch folgende Verfahrensschritte:

a) Leiten eines Lichtstrahls auf ein Interferometer mit zwei im wesentlichen parallelen, reflektierenden Oberflächen, welche im Abstand D angeordnet sind, oder dessen Weglängen um eine Distanz D differieren, und eine Oberfläche ein Ein- oder Mehrschichtensystem (27,41,43) ist und die zu charakterisierenden Schichten bei den gewählten Wellenlängen wenigstens teilweise transparent sind,
b) Leiten wenigstens eines Teils des von den beiden interferierenden Oberflächen reflektierten Lichtes auf ein Gitter (17), wodurch das reflektierte Licht gestreut wird,
c) Fokussieren des gestreuten Lichtes auf eine Photodetektoranordnung (photodetector array) (21),
d) Auswerten der Phase des Interferenzmusters bei jedem Photodetektorelement durch Verwendung der gemessenen Intensitätswerte zur Erzeugung der "gemessenen Phasenfunktion", d.h. Phase der Interferenz als eine Funktion der gemessenen Intensitätswerte;
e) Anpassen des Phasenfunktionsmodells und die gemessene Phasenfunktion, wobei das Phasenfunktionsmodell folgendermassen definiert ist:

$$\Phi(v) = \Phi_0 + \frac{4\pi}{c} Dv + \delta_r(v;n_i, d_i)$$

wobei $\delta_r$ der Phasenanteil des Vielschichtsystems ist, c die Lichtgeschwindigkeit ist, und die fettgedruckten Parameter die Parameter des Phasenfunktionsmodells sind: $\mathbf{n_i}$ und $\mathbf{d_i}$ sind der Brechungsindex und die Dicke der i-ten Schicht;

$\Phi_0$ ist der Phasen-Offset aufgrund des Verfahrens der Phasenbestimmung;
**D** ist der Abstand zwischen den beiden interferierenden Oberflächen oder die Weglängendifferenz zwischen den beiden interferierenden Armen des Interferometers, und

f) Bestimmen der Parameter des Phasenfunktionsmodells, welche am besten mit der gemessenen Phasenfunktion übereinstimmen.

2. Verfahren nach Anspruch 1, **dadurch gekennzeichnet, dass** der Lichtstrahl von einer Breitband oder Vielwellenlängen-Lichtquelle oder einer Leuchtdiode (LED) stammt.

3. Verfahren nach Anspruch 1 oder 2, **dadurch gekennzeichnet, dass** ein Verfahren der kleinsten Quadrate eingesetzt wird, um das Phasenfunktionsmodell an die gemessene Phasenfunktion anzupassen.

4. Verfahren nach einem der Ansprüche 1 bis 3, **dadurch gekennzeichnet, dass** das Gitter (17), der Abstand zwischen benachbarten Pixeln des Photodetektoranordnung (21) und die Brennweite der Relaislinse (29) in Bezug auf den Abstand D und die zentrale Wellenlänge oder Frequenz der Lichtquelle so gewählt und angeordnet werden , dass jeder Pixel der Photodetektoranordnung Licht einer bestimmten Wellenlänge oder Frequenz misst.

5. Verfahren nach Anspruch 4, **dadurch gekennzeichnet, dass** die erwähnten Komponenten so angeordnet werder, dass benachbarte Pixel durch eine Frequenz $\Delta\nu$ entsprechend einer Phasenunterschieds im Interferenzmuster von $\pi/2$ getrennt sind.

6. Verfahren nach einem der Ansprüche 1 bis 5, **dadurch gekennzeichnet, dass** die Zahl der Messpunkte N die Zahl der zu bestimmenden Parameter M übertrifft.

7. Verfahren nach einem der Ansprüche 1 bis 6, **dadurch gekennzeichnet, dass** Schätzungen für die zu bestimmenden Parameter als Ausgangspunkte für das Anpassungsverfahren verwendet werden.

8. Verfahren nach einem der Ansprüche 1 bis 7 zur Verwendung in einer auf totaler interner Reflexion (TIR) basierenden Holographie Konfiguration zur Bestimmung des korrekten Abstands L zwischen einer Hologrammoberfläche (39) und einer beschichteten Substratoberfläche (25), welche in der Nähe und im wesentlichen parallel zur Hologrammoberfläche (39) angeordnet ist.

9. Verfahren nach Anspruch 8, **dadurch gekennzeichnet, dass** das Substrat (27) mit einer oder mehreren Schichten (41,43) beschichtet ist.

10. Verfahren nach Anspruch 8 oder 9, **dadurch gekennzeichnet, dass** die Distanzmessung zur Fokuseinstellung und - erhaltung verwendet wird .

11. Verfahren nach einem der Ansprüche 8 bis 10, **dadurch gekennzeichnet, dass** das Phasenfunktionsmodell geschrieben werden kann als

$$\Phi(\nu) = \Phi_0 + \frac{4\pi}{c}\,L\nu + \delta_r\,(\nu; n_i, d_i)$$

wobei L der zu bestimmende Abstand und die anderen Symbole wie in Anspruch 1 definiert sind.

12. Verfahren nach einem der Ansprüche 8 bis 11, **dadurch gekennzeichnet, dass** eine zweite unabhängige Methode zur Bestimmung des Brechungsindexes und Schichtdicke jeder Schicht verwendet wird und bei welchem Verfahren die bestimmten Parameter weiter dafür verwendet werden, um den Parameter $\delta_r$ zu berechnen, sodass das Phasenfunktionsmodell weniger Parameter hat und die Anpassung an die gemessene Phasenfunktion beschleunigt und vereinfacht wird.

13. Verfahren nach einem der Ansprüche 1 bis 12, zur Ausführung auf einem interferometrischen System zur Messung der Distanz zwischen zwei im wesentlichen parallelen Oberflächen, insbesondere zur Messung des Abstands zwischen zwei Oberflächen, von denen wenigstens eine mit wenigstens einer Schicht beschichtet ist, wobei das System aufweist:

- eine Weisslicht- oder Breitband Lichtquelle (11),
- Mittel zum Kollimieren des Lichtstrahls (13),
- Fokussiermittel (15) zum Fokussieren des Lichtstrahls auf die Oberflächen (39,25,45,47),
- ein Beugungsgitter (17),
- Mittel (19), um das reflektierte Licht auf das erwähnte Beugungsgitter zu leiten und
- einer in Bezug auf das Beugungsgitter (17) und einer Relaislinse (29) angeordneten Photodetektoranordnung (21) zur Detektion des reflektierten und gestreuten Lichtstrahls,

wobei die Gitterkonstante, die Brennweite der Relaislinse (29) und der Pixelabstand der Photodetektoranordnung (21) so bezüglich der zentralen Wellenlänge der Lichtquelle und des ungefähren Abstands L gewählt und angeordnet sind, dass eine synchrone Erfassung mit wenigstens drei Messwerten pro Interferenzringperiode erhalten werden.

14. Verfahren nach Anspruch 13, **dadurch gekennzeichnet, dass** der einfallende Lichtstrahl in einem Winkel von ungefähr 90 Grad einfällt, so dass die reflektierten Strahlen auf der Photodetektoranordnung (21) im wesentlichen zusammenfallen.

15. Verfahren nach Anspruch 13 oder 14, **dadurch gekennzeichnet, dass** ein Strahlteiler (19) das reflektierte Licht auf das Gitter (17) lenkt.

16. Verfahren nach einem der Ansprüche 13 bis 15, **dadurch gekennzeichnet, dass** die zwei Oberflächen das Hologramm und das Substrat in einem auf totaler interner Reflexion basierenden lithographischen System sind und die Distanzmessung zur Bestimmung des Fokusposition verwendet wird.

17. Verfahren nach einem der Ansprüche 13 bis 15, **dadurch gekennzeichnet, dass** die Lichtquelle (11) eine Weisslichtquelle ist.

18. Verfahren nach einem der Ansprüche 13 bis 16, **dadurch gekennzeichnet, dass** die Weisslichtquelle eine Halogenlampe mit einer zentralen Wellenlänge bei 633 nm und einer Bandbreite von ungefähr 100 nm ist, dass die räumliche Periode des Gitters 577.36 nm ist, und der Einfallswinkel des reflektierten Lichtstrahls auf das Gitter 33.2 Grad beträgt, der Abstand zwischen benachbarten Pixeln der Photodetektoranordnung 25 um ist, die Brennweite der Relaislinse 60 mm und der zu bestimmende Abstand ungefähr 125 µm sind.

19. Verfahren nach einem der Ansprüche 1 bis 18 zur Verwendung, beispielsweise, in einem Profilometer zur Bestimmung des Abstands zwischen einer Referenz- und einer profilierten zweiten Oberfläche.

**Revendications**

1. Méthode pour **caractériser** un système de une ou plusieurs couches minces sur un substrat (27), en particulier en ce qui concerne l'épaisseur et l'indice de réfraction des couches, par interférométrie, en particulier par interférométrie en lumière blanche à spectre discrétisé ou par interférométrie à longueurs d'onde multiples, comprenant les étapes suivantes :

a) orientation d'un faisceau lumineux en direction d'un interféromètre comprenant deux surfaces réfléchissantes essentiellement patallèles, séparées par, ou dont la longueur des chemins diffère de, une distance D, et dont une des surfaces est un système mono ou multicouche (27, 41,43), et dont les couches à **caractériser** sont au moins partiellement transparentes aux longueurs d'onde choisies
b) orientation d'au moins une partie de la lumière réfléchie par les deux surfaces interférentes sur un réseau (17), celui-ci dispersant la lumière réfléchie,
c) focalisation de la lumière dispersée sur une matrice de photo-détecteurs (21),
d) évaluation de la phase de la figure d'interférence en chaque élément de la matrice de photo-détecteurs en utilisant les valeurs des intensités mesurées pour établir la fonction de phase mesurée, c'est-à-dire la phase de l'interférence en fonction de la fréquence,

e) adaptation de la fonction de phase modèle à la fonction de phase mesurée, pour laquelle la fonction de phase modèle est la suivante :

$$\Phi(\nu) = \Phi_0 + \frac{4\pi}{c}D\nu + \delta_r(\nu;n_i,d_i)$$

où $\delta_r$ est la contribution à la phase du système multicouche, c la vitesse de la lumière et les paramètres en gras ceux de la fonction de phase modèle: $\mathbf{n_i}$ et $\mathbf{d_i}$ sont, respectivement, les indice de réfraction et l'épaisseur de la couche i;

$\Phi_0$ est le décalage dé phase dû à la méthode de détermination de la phase;
D est la distance entre les deux surfaces interférentes ou bien la différence de chemin entre les deux bras de l'interféromètre, et

f) détermination des paramètres de la fonction de phase modèle qui permettent la meilleure adaptation à la fonction de phase mesurée.

2. Méthode en rapport à la revendication 1 par laquelle le faisceau lumineux provient d'une source à large bande ou à longueurs d'onde multiples ou d'une diode électroluminescente.

3. Méthode en rapport à la revendication 1 ou 2 par laquelle une méthode des moindres carrés est utilisée pour adapter la fonction de phase modèle à la fonction de phase mesurée.

4. Méthode en rapport à une des revendications 1 à 3 par laquelle le réseau (17), la distance entre les pixels adjacents de la matrice du photo-détecteur (21) et la distance focale de la lentille de relais (29) sont choisis et disposés en rapport à la distance D et la longueur d'onde ou la fréquence centrale de la source d'illumination de manière à ce que chaque pixel de la matrice de photo-détecteurs mesure la lumière dîme longueur d'onde ou de la fréquence sélectionnée.

5. Méthode en rapport avec la revendication 4 par laquelle les dits composants sont disposés de telle manière que les pixels adjacents sont séparés par une fréquence $\Delta\nu$ correspondant à une séparation de phase dans la figure d'interférence de $\pi/2$.

6. Méthode en rapport avec une des revendications 1 à 5 par laquelle le nombre de points de mesure N dépasse le nombre de paramètres M à déterminer.

7. Méthode en rapport avec une des revendications 1 à 6 par laquelle des estimations pour les paramètres à déterminer sont pris comme points de départ pour la procédure d'adaptation.

8. Méthode en rapport avec les revendications 1 à 7 utilisée dans une configuration d'holographie par réflexion totale interne pour déterminer la distance correcte L entre la surface d'un hologramme (39) et la surface d'un substrat (25) couché qui est disposée à proximité et essentiellement parallèlement à la surface de l'hologramme (39).

9. Méthode en rapport avec la revendication 8 par laquelle le substrat (27) est recouvert de une ou plusieurs couches (41, 43).

10. Méthode en rapport avec les revendications 8 et 9 par laquelle la mesure de distance est employée pour ajuster et maintenir la focalisation.

11. Méthode en rapport avec une des revendications 8 à 10 par laquelle la fonction de phase modèle peut s'écrire ainsi

$$\Phi(\nu) = \Phi_0 + \frac{4\pi}{c}L\nu + \delta_r(\nu;n_i,d_i)$$

où L est la distance à mesurer et les autres symboles tels que définis dans la revendication 1.

12. Méthode en rapport avec l'une des revendications 8 à 11 par laquelle une deuxième méthode indépendante est employée pour déterminer l'indice de réfraction et l'épaisseur de chaque couche et dans laquelle les paramètres

**13**

déterminés sont ensuite utilisés pour calculer la valeur de $\delta_r$ si bien que la fonction de phase modèle contient moins de paramètres, accélérant et simplifiant ainsi son adaptation à la fonction de phase mesurée.

13. Méthode en rapport avec les revendication 1 à 12 par laquelle la méthode est utilisée pour un système interferométrique pour mesurer la distance entre deux surfaces essentiellement parallèles, et plus particulièrement pour mesurer la distance entre deux surfaces, étant entendu que l'une au moins des dites surfaces est recouverte d'au moins une couche, les systèmes comprenant :

    - une source de lumière blanche ou à large bande (11),
    - un système de collimation pour collimater le faisceau lumineux (13),
    - un système de focalisation (15) pour focaliser le faisceau lumineux sur les surfaces (39, 25, 45, 47),
    - un réseau de diffraction (17),
    - un système (19) pour diriger la lumière réfléchie en direction dudit réseau de diffraction et
    - une matrice de photo-détecteurs (21) disposée en rapport au réseau de diffraction (17) et à une lentille de relais (29) pour détecter lo faisceau de lumière réfléchie et dispersée

    dans lequel le pas du réseau, la distance focale de la lentille de relais (29) et l'espacement des pixels de la matrice des photo-détecteurs (21) sont choisis et disposés en relation avec la longueur d'onde de la source lumineuse et la distance L approximative, afin d'obtenir un échantillonnage synchrone avec au moins 3 échantillons par période de franges d'interférence.

14. Méthode en rapport avec la revendication 13 par laquelle le faisceau lumineux incident fait un angle d'environ 90° afin que les rayons réfléchis coïncident essentiellement avec la matrice de photo-détecteurs.

15. Méthode en rapport avec la revendication 13 ou 14 par laquelle un séparateur de faisceau (19) dévie la lumière réfléchie en direction du réseau (17).

16. Méthode en rapport avec les revendications 13 à 15 par laquelle les deux surfaces sont celles de l'hologramme et du substrat dans un système de lithographie holographique à réflexion interne totale et la mesure de la distance est utilisée pour déterminer la position de focalisation.

17. Méthode en rapport avec une des revendications 13 à 16 par laquelle la source lumineuse (11) est une source de lumière blanche.

18. Méthode en rapport avec une des revendications 13 à 16 par laquelle la source de lumière blanche (11) est une lampe halogène émettant à une longueur d'onde centrale de 633 nm avec une largeur spectrale approximative de 100 nm, la période spatiale pour le réseau est de 577,36 nm et l'angle d'incidence pour le rayon lumineux réfléchi sur le réseau de 33,2 degrés, la distance entre les pixels adjacents du photo-détecteur est de 25 microns, la distance focale de la lentille relais est de 60 mm et la distance à mesurer est approximativement 125 microns,

19. Méthode en rapport avec la revendication 1 à 18 pour utilisation, par exemple dans un profilomètre pour déterminer la distance entre un surface de référence et une seconde surface profilée.

Fig. 1

EP 0 747 666 B1

Fig. 2

Fig. 3

EP 0 747 666 B1

| $d_{res}[\mu m]$ | | $d_{SiO2}[\mu m]$ | | $L_{uc}[\mu m]$ | $L_c[\mu m]$ | $\Delta L[\mu m]$ |
|---|---|---|---|---|---|---|
| mech. | opt. | mech. | opt. | | | |
| 1.295 | 1.289 | 0.298 | 0.299 | 126.45 | 124.14 | 2.31 |
| 1.490 | 1.483 | 0.298 | 0.303 | 125.89 | 123.15 | 2.74 |
| 1.195 | 1.198 | 0.897 | 0.889 | 123.89 | 120.64 | 3.25 |
| 1.290 | 1.295 | 0.897 | 0.890 | 123.96 | 120.29 | 3.67 |
| 1.455 | 1.463 | 0.897 | 0.884 | 126.47 | 122.63 | 3.84 |

Fig. 5

| $d_{res}[\mu m]$ | | $L_{uc}[\mu m]$ | $L_c[\mu m]$ | $\Delta L[\mu m]$ |
|---|---|---|---|---|
| mech. | opt. | | | |
| 1.145 | 1.142 | 126.37 | 123.74 | 2.63 |
| 1.198 | 1.202 | 125.27 | 123.53 | 1.74 |
| 1.266 | 1.259 | 125.14 | 122.68 | 2.46 |
| 1.338 | 1.342 | 126.63 | 122.48 | 2.15 |
| 1.421 | 1.419 | 124.09 | 122.80 | 1.29 |

Fig. 4